# EUROPEAN PATENT APPLICATION

(11) **EP 4 577 020 A1**
(43) Date of publication of application: **25.06.2025**
(21) Application number: 24215044.9
(22) Date of filing: 25.11.2024
(51) Int. Cl.: H10K 59/122, H10K 59/173

(54) **DISPLAY DEVICE AND METHOD FOR MANUFACTURING THE SAME**

(30) Priority: 20.12.2023 KR 20230187294
(71) Applicant: Samsung Display Co., Ltd., Yongin-si, Gyeonggi-do 17113 (KR)
(72) Inventor: SHIN, Hyun Eok, 17113 Giheung-gu, Yongin-si, Gyeonggi-do (KR)
(74) Representative: Dr. Weitzel & Partner

(57) **Abstract**

A display device includes a first bank pattern above a substrate, a second bank pattern including a side protruding further than the first bank pattern, and a pixel electrode above the second bank pattern.

## Description

### BACKGROUND

### 1. Field

The present invention relates to a display device, and a method for manufacturing the same.

### 2. Description of Related Art

With the advancement of the information age, the desire for a display device for displaying an image has increased with various forms. For example, the display device has been applied to various electronic devices, such as a smart phone, a digital camera, a laptop computer, a navigator, and a smart television. The display device may be a flat panel display device, such as a liquid crystal display device, a field emission display device, and an organic light-emitting display device. Among such flat panel display devices, the light-emitting display device includes a light-emitting element in which each of pixels of a display panel may self-emit light, thereby displaying an image even without a backlight that provides the display panel with light.

Recently, the display device has been applied to a glasses-type device for providing virtual reality and augmented reality. To be applied to the glasses-type device, the display device may be implemented at a very small size of about 2 inches or less, but it should have high pixel integration so that it may be implemented at high resolution. For example, the display device may have high pixel integration of about 1000 pixels per inch (PPI) or more.

As described above, the display device is implemented at a very small size, but an area of a light emission area in which a light-emitting element is located may be reduced when the display device has high pixel integration. Therefore, it may be difficult to implement light-emitting elements separated for each light emission area by a mask process.

### SUMMARY

An aspect of the present invention provides a display device that may form pixel electrodes, which are spaced apart from each other, without a mask process.

Another aspect of the present invention provides a light-emitting element having a narrow non-display area.

The aspects of the present invention are not limited to those mentioned above and additional aspects of the present invention, which are not mentioned herein, will be clearly understood by those skilled in the art from the following description of the present invention. The invention is defined by the features of the independent claims. The dependent claims describe preferred embodiments.

According to one or more embodiments of the present invention, a display device includes a substrate, a first bank pattern above the substrate, a second bank pattern above the first bank pattern and including a side protruding further than the first bank pattern, and a pixel electrode above the second bank pattern.

The first bank pattern and the second bank pattern may include different respective metals or alloys.

The first bank pattern may include aluminum or an aluminum alloy, wherein the second bank pattern includes titanium or a titanium alloy.

The substrate may include a first light emission area and a second light emission area spaced apart from each other, wherein the display device further including a residual pattern in a space between the first light emission area and the second light emission area.

The residual pattern may include a same material as the pixel electrode.

The residual pattern may be lower than the second bank pattern.

The display device may further include a pixel-defining layer surrounding the first bank pattern, the second bank pattern, and the pixel electrode, above the residual pattern.

The pixel-defining layer may be above a lower surface of the second bank pattern.

A distance between a side of the first bank pattern and a side of the second bank pattern may be greater than a thickness of the first bank pattern.

The distance between the side of the first bank pattern and the side of the second bank pattern may be about three times to about five times the thickness of the first bank pattern.

The pixel electrode may be on an upper surface and a side of the second bank pattern.

The pixel electrode may include a first layer including a metal above the second bank pattern, and a second layer including a transparent conductive oxide (TCO) above the first layer.

The pixel electrode may further include a third layer including a metal between the second bank pattern and the first layer.

The display device may further include a first interlayer insulating layer between the substrate and the first bank pattern in the first light emission area and in the second light emission area.

The first interlayer insulating layer in the first light emission area and the first interlayer insulating layer in the second light emission area may be spaced apart from each other, wherein the residual pattern is in a gap space of the first interlayer insulating layer.

The first bank pattern and the second bank pattern may include island patterns.

According to one or more embodiments of the present invention, a display device includes a substrate including light emission areas spaced apart from each other, a first bank pattern above the substrate in the light emission areas, a second bank pattern above the first bank pattern, and including a side protruding further than the first bank pattern, a pixel electrode above the second bank pattern, a residual pattern above the substrate between the light emission areas, a pixel-defining layer above the residual pattern and the pixel electrode, and a light-emitting layer above the pixel electrode and the pixel-defining layer.

According to one or more embodiments of the present invention, a method for manufacturing a display device includes forming a first bank layer above a substrate, forming a second bank layer above the first bank layer, removing a portion of the second bank layer and the first bank layer, etching a side of the first bank layer to expose a portion of a lower surface of the second bank layer, forming a pixel electrode above the second bank layer, and forming a residual pattern above the substrate.

The forming a pixel electrode above the second bank layer and the forming a residual pattern above the substrate may include dividing a material deposited on the substrate into the pixel electrode and the residual pattern by being disconnected by a protruded side of the second bank layer extending further than the first bank layer.

The removing a portion of the second bank layer and the first bank layer may include forming a mask pattern above the second bank layer, and etching the second bank layer and the first bank layer in an area not covered with the mask pattern.

In the display device and the method for manufacturing the same according to one or more embodiments, a bank structure of an undercut structure is provided below pixel electrodes, so that a gap between the pixel electrodes may be reduced, and high resolution may be implemented.

The aspects according to the embodiments of the present invention are not limited to those mentioned above and more various aspects are included in the following description of the present invention.

### BRIEF DESCRIPTION OF THE DRAWINGS

The above and other aspects of the present invention will become more apparent by describing in detail embodiments thereof with reference to the attached drawings, in which:
FIG. 1 is a perspective view illustrating a head mounted display device according to one or more embodiments;
FIG. 2 is an exploded perspective view illustrating an example of the head mounted display device of FIG. 1;
FIG. 3 is a perspective view illustrating a head mounted display device according to one or more embodiments;
FIG. 4 is an exploded perspective view illustrating a display device according to one or more embodiments;
FIG. 5 is a cross-sectional view illustrating an example in which a portion of a display panel according to one or more embodiments is cut;
FIG. 6 is an enlarged view illustrating an area A1 of FIG. 5;
FIGS. 7 to 9 are cross-sectional views illustrating a portion of a display panel according to one or more embodiments; and
FIGS. 10 to 16 are cross-sectional views sequentially illustrating a process of manufacturing a display device according to one or more embodiments.

### DETAILED DESCRIPTION

Aspects of some embodiments of the present invention and methods of accomplishing the same may be understood more readily by reference to the detailed description of embodiments and the accompanying drawings. The described embodiments are provided as examples so that this disclosure will be thorough and complete, and will fully convey the aspects of the present invention to those skilled in the art. Accordingly, processes, elements, and techniques that are redundant, that are unrelated or irrelevant to the description of the embodiments, or that are not necessary to those having ordinary skill in the art for a complete understanding of the aspects of the present invention may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present invention.

A person of ordinary skill in the art would appreciate, in view of the present disclosure in its entirety, that the present invention covers all modifications and replacements within the idea and technical scope of the present invention, that each of the features of embodiments of the present invention may be combined with each other, in part or in whole, and technically various interlocking and operating are possible, and that each embodiment may be implemented independently of each other, or may be implemented together in an association, unless otherwise stated or implied.

In the drawings, the relative sizes of elements, layers, and regions may be exaggerated for clarity and/or descriptive purposes. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present invention. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present invention. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present invention. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present invention refers to "one or more embodiments of the present invention."

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

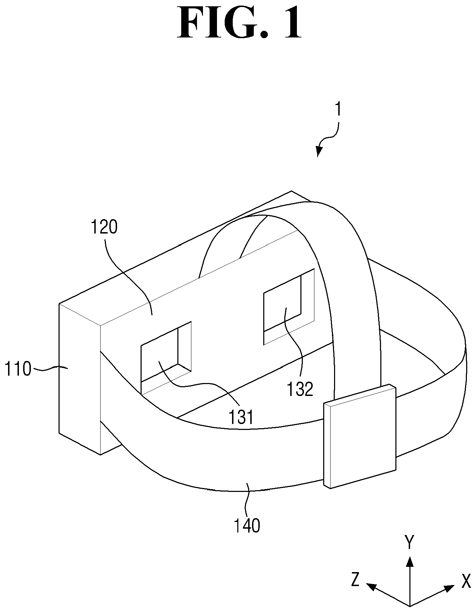

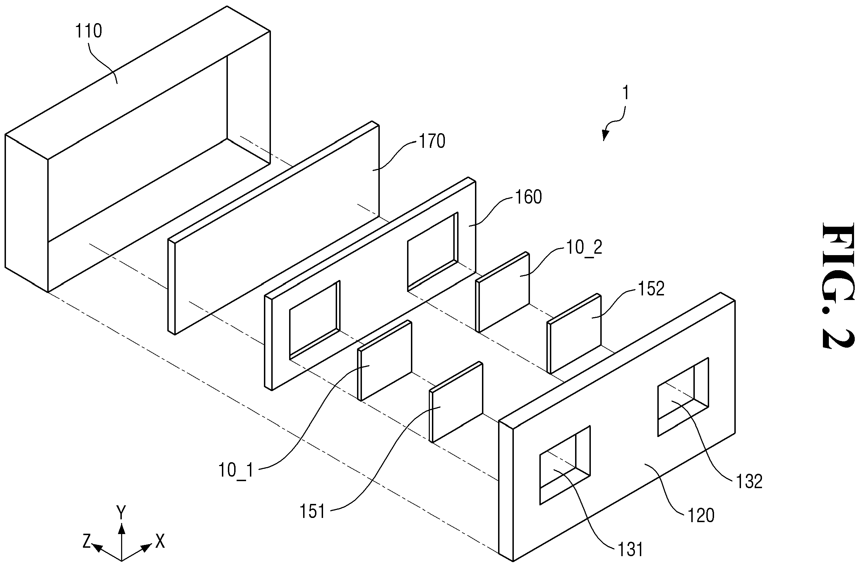

FIG. 1 is a perspective view illustrating a head mounted display device according to one or more embodiments. FIG. 2 is an exploded perspective view illustrating an example of the head mounted display device of FIG. 1.

Referring to FIGS. 1 and 2, the head mounted display device 1 according to one or more embodiments includes a first display device 10_1, a second display device 10_2, a display device accommodating portion 110, a storage cover (e.g., a display device accommodating portion) 120, a first eyepiece 131, a second eyepiece 132, a head-mounted band 140, a middle frame 160, a first optical member 151, a second optical member 152, a control circuit board 170, and a connector.

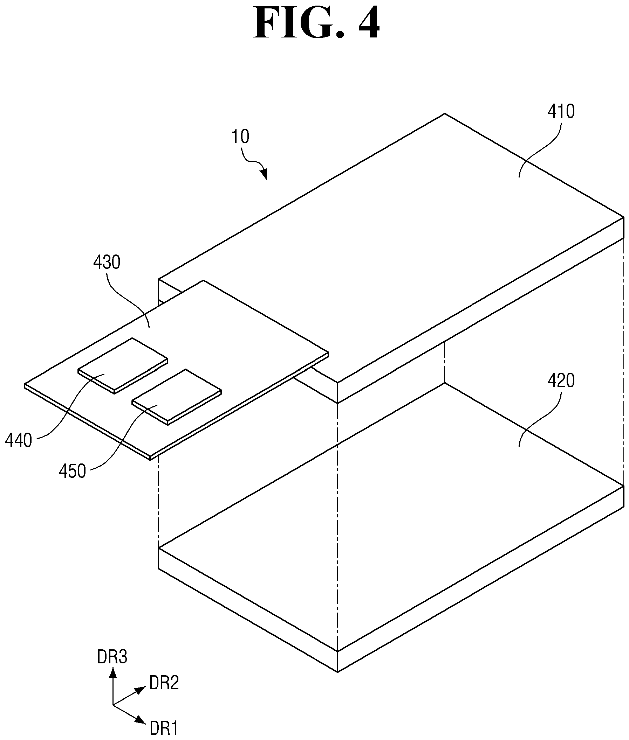

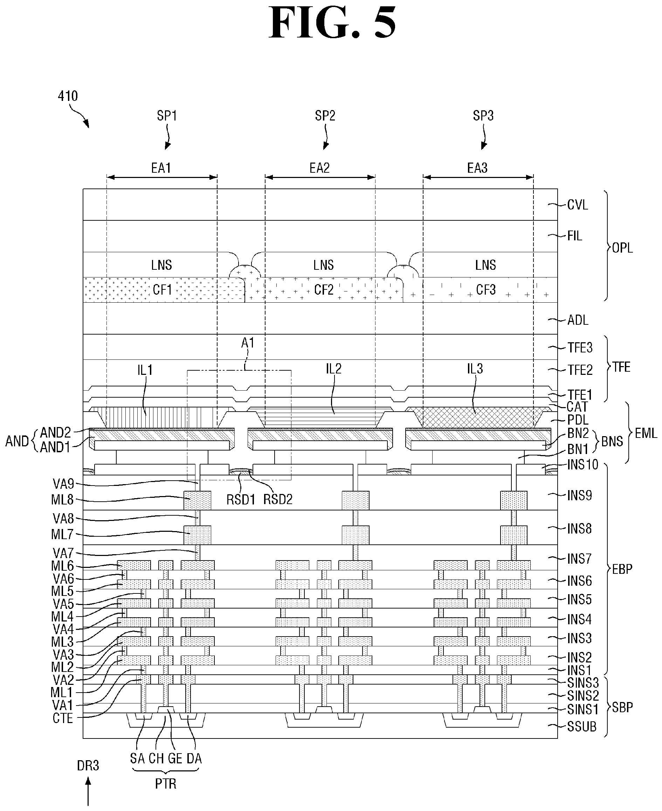

The first display device 10_1 provides an image to a user's left eye, and the second display device 10_2 provides an image to the user's right eye. Each of the first display device 10_1 and the second display device 10_2 is substantially the same as a display device 10 that will be described with reference to FIGS. 4 and 5. Therefore, the descriptions of the first display device 10_1 and the second display device 10_2 will be replaced by the descriptions made with reference to FIGS. 4 and 5.

The first optical member 151 may be located between the first display device 10_1 and the first eyepiece 131. The second optical member 152 may be located between the second display device 10_2 and the second eyepiece 132. Each of the first optical member 151 and the second optical member 152 may include at least one convex lens.

The middle frame 160 may be located between the first display device 10_1 and the control circuit board 170, and may be located between the second display device 10_2 and the control circuit board 170. The middle frame 160 serves to support and fix the first display device 10_1, the second display device 10_2 and the control circuit board 170.

The control circuit board 170 may be located between the middle frame 160 and the display device accommodating portion 110. The control circuit board 170 may be connected to the first display device 10_1 and the second display device 10_2 through the connector. The control circuit board 170 may convert an image source input from the outside into digital video data, and may transmit the digital video data to the first display device 10_1 and the second display device 10_2 through the connector.

The control circuit board 170 may transmit digital video data corresponding to a left-eye image suitable for the user's left eye to the first display device 10_1, and may transmit digital video data corresponding to a right-eye image suitable for the user's right eye to the second display device 10_2. Alternatively, the control circuit board 170 may transmit the same digital video data to the first display device 10_1 and the second display device 10_2.

The display device accommodating portion 110 serves to accommodate the first display device 10_1, the second display device 10_2, the middle frame 160, the first optical member 151, the second optical member 152, the control circuit board 170 and the connector. The storage cover 120 is located to cover one open surface of the display device accommodating portion 110. The storage cover 120 may include a first eyepiece 131 in which the user's left eye is located and a second eyepiece 132 in which the user's right eye is located. Although FIGS. 1 and 2 illustrate that the first eyepiece 131 and the second eyepiece 132 are located separately, the present invention is not limited thereto. The first eyepiece 131 and the second eyepiece 132 may be combined into one.

The first eyepiece 131 may be aligned with the first display device 10_1 and the first optical member 151, and the second eyepiece 132 may be aligned with the second display device 10_2 and the second optical member 152. Therefore, the user may view the image of the first display device 10_1, which is enlarged in a virtual image by the first optical member 151, through the first eyepiece 131, and may view the image of the second display device 10_2, which is enlarged in a virtual image by the second optical member 152, through the second eyepiece 132.

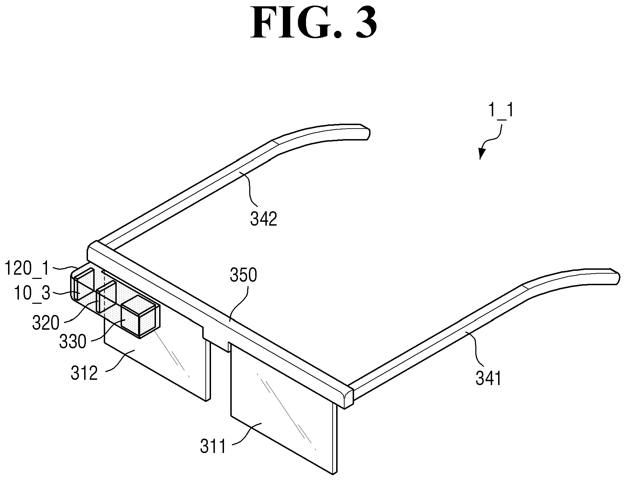

The head-mounted band 140 serves to fix the display device accommodating portion 110 to the user's head so that the first eyepiece 131 and the second eyepiece 132 of the storage cover 120 are located on the user's left and right eyes, respectively. When the display device accommodating portion 110 is implemented to be lightweight and small, the head mounted display device 1 may include a glasses frame, as shown in FIG. 3, instead of the head-mounted band 140.

In addition, the head mounted display device 1 may further include a battery for supplying a power source, an external memory slot capable of accommodating an external memory, an external connection port for receiving an image source, and a wireless communication module. The external connection port may be a universal serial bus (USB) terminal, a display port or a high-definition multimedia interface (HDMI) terminal, and the wireless communication module may be a 5G communication module, a 4G communication module, a Wi-Fi^{®} module or a Bluetooth^{®} module (Wi-Fi^{®} being a registered trademark of the non-profit Wi-Fi Alliance, and Bluetooth^{®} being a registered trademark of Bluetooth Sig, Inc., Kirkland, WA).

FIG. 3 is a perspective view illustrating a head mounted display device according to one or more embodiments.

Referring to FIG. 3, a head mounted display device 1_1 according to one or more embodiments may be a glasses-type display device in which a display device accommodating portion 120_1 is implemented to be lightweight and small. The head mounted display device 1_1 according to one or more embodiments may include a display device 10_3, a left-eye lens 311, a right-eye lens 312, a support frame 350, glasses frame legs 341 and 342, an optical member 320, an optical path conversion member 330, and a display device accommodating portion 120_1.

The display device 10_3 shown in FIG. 3 is substantially the same as the display device 10 described with reference to FIGS. 4 and 5. Therefore, the descriptions of the first display device 10_1 and the second display device 10_2 will be replaced by the descriptions shown in FIGS. 4 and 5.

The display device accommodating portion 120_1 may include a display device 10_3, an optical member 320, and an optical path conversion member 330. An image displayed on the display device 10_3 may be enlarged by the optical member 320, and an optical path may be converted by the optical path conversion member 330 so that the image may be provided to the user's right eye through the right-eye lens 312. For this reason, the user may view an augmented reality image in which a virtual image displayed on the display device 10_3 and a real image viewed through the right-eye lens 312 are combined through the right eye.

Although FIG. 3 illustrates that the display device accommodating portion 120_1 is located at the right end of the support frame 350, the present invention is not limited thereto. For example, the display device accommodating portion 120_1 may be located at the left end of the support frame 350, and in this case, the image of the display device 10_3 may be provided to the user's left eye. Alternatively, the display device accommodating portion 120_1 may be located at both the left end and the right end of the support frame 350, and in this case, the user may view the image displayed on the display device 10_3 through both the left eye and the right eye.

FIG. 4 is an exploded perspective view illustrating a display device according to one or more embodiments.

Referring to FIG. 4, the display device 10 according to one or more embodiments is a device for displaying a moving image or a still image. The display device 10 according to one or more embodiments may be applied to a portable electronic device, such as a mobile phone, a smart phone, a tablet personal computer (PC), a mobile communication terminal, an electronic diary, an electronic book, a portable multimedia player (PMP), a navigator, and an ultra-mobile PC (UMPC). For example, the display device 10 may be applied to a television, a laptop computer, a monitor, a signboard, or a display unit of Internet of things (IoT). Also, the display device 10 may be applied to a smart watch, a watch phone, and a head mounted display (HMD) for implementing virtual reality and augmented reality.

The display device 10 according to one or more embodiments includes a display panel 410, a heat dissipation layer 420, a circuit board 430, a driving circuit 440 and a power supply circuit 450.

The display panel 410 may be formed in a planar shape similar to a rectangular shape. For example, the display panel 410 may have a planar shape similar to a rectangular shape having short sides in a first direction DR1, and long sides in a second direction DR2. A corner where the short side in the first direction DR1 and the long side in the second direction DR2 meet in the display panel 410 may be rounded to have a curvature (e.g., predetermined curvature) or formed at a right angle. The planar shape of the display panel 410 may be formed to be similar to other polygonal shape, a circular shape, or an oval shape, without being limited to the rectangular shape. A planar shape of the display device 10 may follow the planar shape of the display panel 410, but the present invention is not limited thereto.

The display panel 410 includes a display area for displaying an image, and a non-display area for not displaying an image.

The display area includes a plurality of pixels, and each of the pixels includes a plurality of subpixels (SP1, SP2, and SP3 of FIG. 5). The plurality of subpixels SP1, SP2, and SP3 include a plurality of pixel transistors. The plurality of pixel transistors may be formed through a semiconductor process, and may be located on (as used herein, "located on" may mean "above") a semiconductor substrate (SSUB of FIG. 5). For example, the plurality of pixel transistors may be formed of complementary metal oxide semiconductors (CMOS).

The heat dissipation layer 420 may overlap the display panel 410 in a third direction DR3 that is a thickness direction of the display panel 410. The heat dissipation layer 420 may be located on one surface of the display panel 410, for example, a rear surface. The heat dissipation layer 420 serves to emit heat generated from the display panel 410. The heat dissipation layer 420 may include a metal layer, such as graphite, silver (Ag), copper (Cu), or aluminum (Al), which has high thermal conductivity.

The circuit board 430 may be electrically connected to a plurality of pads PD of a pad area of the display panel 410 by using a conductive adhesive member, such as an anisotropic conductive film. The circuit board 430 may be a flexible printed circuit board or a flexible film, which has a flexible material. Although FIG. 4 illustrates that the circuit board 430 is unfolded, the circuit board 430 may be bent. In this case, one end of the circuit board 430 may be located on the rear surface of the display panel 410. One end of the circuit board 430 may be opposite to the other end of the circuit board 430 connected to the plurality of pads of the pad area of the display panel 410 by using a conductive adhesive member.

The driving circuit 440 may receive digital video data and timing signals from the outside. The driving circuit 440 may generate a scan-timing control signal, an emission-timing control signal, and a data-timing control signal, which are intended for controlling the display panel 410 in accordance with the timing signals.

The power supply circuit 450 may generate a plurality of panel-driving voltages in accordance with a power voltage from the outside. For example, the power supply circuit 450 may generate a first driving voltage (e.g., VSS), a second driving voltage (e.g., VDD), and a third driving voltage (e.g., VINT), and may supply them to the display panel 410.

Each of the driving circuit 440 and the power supply circuit 450 may be formed of an integrated circuit (IC), and may be attached to one surface of the circuit board 430.

FIG. 5 is a cross-sectional view illustrating an example in which a portion of a display panel according to one or more embodiments is cut. For example, FIG. 5 illustrates a partial cross-sectional structure of a display area that includes a plurality of subpixels SP1, SP2, and SP3 of FIG. 5.

Referring to FIG. 5, the display panel 410 may include a semiconductor backplane SBP, a light-emitting element backplane EBP, a light-emitting element layer EML, an encapsulation layer TFE, an optical layer OPL, a cover layer CVL, and a polarizing plate, in one or more embodiments.

The semiconductor backplane SBP includes a semiconductor substrate SSUB including a plurality of pixel transistors PTR, a plurality of semiconductor-insulating layers covering the plurality of pixel transistors PTR, and a plurality of contact terminals CTE electrically connected to the plurality of pixel transistors PTR.

The semiconductor substrate SSUB may be a silicon substrate, a germanium substrate, or a silicon-germanium substrate. The semiconductor substrate SSUB may be a substrate doped with first type impurities. A plurality of well areas may be located on an upper surface of the semiconductor substrate SSUB. The plurality of well areas may be an area doped with second type impurities. The second type impurities may be different from the first type impurities. For example, when the first type impurities are p-type impurities, the second type impurities may be n-type impurities. Alternatively, when the first type impurities are n-type impurities, the second type impurities may be p-type impurities.

Each of the plurality of well areas includes a source area SA corresponding to a source electrode of the pixel transistor PTR, a drain area DA corresponding to a drain electrode, and a channel area CH located between the source area SA and the drain area DA.

Each of the source area SA and the drain area DA may be doped with the first type impurities. A gate electrode GE of the pixel transistor PTR may overlap the well area in the third direction DR3. The channel area CH may overlap the gate electrode GE in the third direction DR3. The source area SA may be located at one side of the gate electrode GE, and the drain area SA may be located at the other side of the gate electrode GE.

The first semiconductor-insulating layer SINS1 may be located on the semiconductor substrate SSUB. The first semiconductor-insulating layer SINS1 may be formed of an inorganic film of silicon carbon nitride (SiCN) or silicon oxide (SiOx), but the present invention is not limited thereto.

The second semiconductor-insulating layer SINS2 may be located on the first semiconductor-insulating layer SINS1. The second semiconductor-insulating layer SINS2 may be formed of an inorganic film of silicon oxide (SiOx), but the present invention is not limited thereto.

The plurality of contact terminals CTE may be located on the second semiconductor-insulating layer SINS2. Each of the plurality of contact terminals CTE may be connected to one of the gate electrode GE, the source area SA, and the drain area DA of each of the pixel transistors PTR through a hole passing through the first semiconductor-insulating layer SINS1 and the second semiconductor-insulating layer SINS2. The contact terminals CTE may include any one of copper (Cu), aluminum (Al), tungsten (W), molybdenum (Mo), chromium (Cr), gold (Au), titanium (Ti), nickel (Ni), or neodymium (Nd), or an alloy including any one of them.

The third semiconductor-insulating layer SINS3 may be located on sides of each of the plurality of contact terminals CTE. An upper surface of each of the plurality of contact terminals CTE may be exposed without being covered by the third semiconductor-insulating layer SINS3. The third semiconductor-insulating layer SINS3 may be formed of an inorganic film of silicon oxide (SiOx), but the present invention is not limited thereto.

The semiconductor substrate SSUB may be replaced with a glass substrate or a polymer resin substrate, such as polyimide. In this case, thin film transistors may be located on the glass substrate or the polymer resin substrate. The glass substrate may be a rigid substrate that is not bent, and the polymer resin substrate may be a flexible substrate that may be bent or curved.

The light-emitting element backplane EBP may include first to eighth metal layers ML1, ML2, ML3, ML4, ML5, ML6, ML7, and ML8, a plurality of vias VA1, VA2, VA3, VA4, VA5, VA6, VA7, VA8, and VA9, and a plurality of interlayer insulating layers INS1 to INS10.

The first to eighth metal layers ML1, ML2, ML3, ML4, ML5, ML6, ML7, and ML8 serves to implement a circuit of the subpixels SP1, SP2, and SP3 by connecting the plurality of contact terminals CTE exposed from the semiconductor backplane SBP.

The first interlayer insulating layer INS1 may be located on the semiconductor backplane SBP. The first via VA1 may be connected to the contact terminal CTE exposed from the semiconductor backplane SBP by passing through the first interlayer insulating layer INS1. The first metal layer ML1 may be located on the first interlayer insulating layer INS1, and may be connected to the first via VA1.

The second interlayer insulating layer INS2 may be located on the first interlayer insulating layer INS1 and the first metal layer ML1. The second via VA2 may be connected to the first metal layer ML1 exposed by passing through the second interlayer insulating layer INS2. The second metal layer ML2 may be located on the second interlayer insulating layer INS2, and may be connected to the second via VA2.

The third interlayer insulating layer INS3 may be located on the second interlayer insulating layer INS2 and the second metal layer ML2. The third via VA3 may be connected to the second metal layer ML2 exposed by passing through the third interlayer insulating layer INS3. The third metal layer ML3 may be located on the third interlayer insulating layer INS3, and may be connected to the third via VA3.

The fourth interlayer insulating layer INS4 may be located on the third interlayer insulating layer INS3 and the third metal layer ML3. The fourth via VA4 may be connected to the third metal layer ML3 exposed by passing through the fourth interlayer insulating layer INS4. The fourth metal layer ML4 may be located on the fourth interlayer insulating layer INS4, and may be connected to the fourth via VA4.

The fifth interlayer insulating layer INS5 may be located on the fourth interlayer insulating layer INS4 and the fourth metal layer ML4. The fifth via VA5 may be connected to the fourth metal layer ML4 exposed by passing through the fifth interlayer insulating layer INS5. The fifth metal layer ML5 may be located on the fifth interlayer insulating layer INS5, and may be connected to the fifth via VA5.

The sixth interlayer insulating layer INS6 may be located on the fifth interlayer insulating layer INS5 and the fifth metal layer ML5. The sixth via VA6 may be connected to the fifth metal layer ML5 exposed by passing through the sixth interlayer insulating layer INS6. The sixth metal layer ML6 may be located on the sixth interlayer insulating layer INS6, and may be connected to the sixth via VA6.

The seventh interlayer insulating layer INS7 may be located on the sixth interlayer insulating layer INS6 and the sixth metal layer ML6. The seventh via VA7 may be connected to the sixth metal layer ML6 exposed by passing through the seventh interlayer insulating layer INS7. The seventh metal layer ML7 may be located on the seventh interlayer insulating layer INS7, and may be connected to the seventh via VA7.

The eighth interlayer insulating layer INS8 may be located on the seventh interlayer insulating layer INS7 and the seventh metal layer ML7. The eighth via VA8 may be connected to the seventh metal layer ML7 exposed by passing through the eighth interlayer insulating layer INS8. The eighth metal layer ML8 may be located on the eighth interlayer insulating layer INS8, and may be connected to the eighth via VA8.

The contact terminals CTE of the semiconductor backplane SBP and the first to sixth metal layers ML1, ML2, ML3, ML4, ML5, and ML6 of the light-emitting element backplane EBP may be connected to the drain area DA, the source area SA, and the gate electrode GE of the pixel transistor PTR. The seventh and eighth metal layers ML7 and ML8 may not be connected to the source area SA and the gate electrode GE, but may be connected to the drain area DA.

The first to eighth metal layers ML1, ML2, ML3, ML4, ML5, ML6, ML7, and ML8 and the first to eighth vias VA1, VA2, VA3, VA4, VA5, VA6, VA7, and VA8 may include substantially the same material. The first to eighth metal layers ML1, ML2, ML3, ML4, ML5, ML6, ML7, and ML8 and the first to eighth vias VA1, VA2, VA3, VA4, VA5, VA6, VA7, and VA8 may include any one of copper (Cu), aluminum (Al), tungsten (W), molybdenum (Mo), chromium (Cr), gold (Au), titanium (Ti), nickel (Ni), or neodymium (Nd), or an alloy including any one of them. The first to ninth interlayer insulating layers INS1, INS2, INS3, INS4, INS5, INS6, INS7, INS8, and INS9 may include an inorganic film of silicon oxide (SiOx), but the present invention is not limited thereto.

A thickness of the first metal layer ML1, a thickness of the second metal layer ML2, a thickness of the third metal layer ML3, a thickness of the fourth metal layer ML4, a thickness of the fifth metal layer ML5, and a thickness of the sixth metal layer ML6 may be greater than a thickness of the first via VA1, a thickness of the second via VA2, a thickness of the third via VA3, a thickness of the fourth via VA4, a thickness of the fifth via VA5, and a thickness of the sixth via VA6, respectively. Each of the thickness of the second metal layer ML2, the thickness of the third metal layer ML3, the thickness of the fourth metal layer ML4, the thickness of the fifth metal layer ML5, and the thickness of the sixth metal layer ML6 may be greater than the thickness of the first metal layer ML1. The thickness of the second metal layer ML2, the thickness of the third metal layer ML3, the thickness of the fourth metal layer ML4, the thickness of the fifth metal layer ML5, and the thickness of the sixth metal layer ML6 may be substantially the same as one another.

Each of a thickness of the seventh metal layer ML7 and a thickness of the eighth metal layer ML8 may be greater than each of the thickness of the first metal layer ML1, the thickness of the second metal layer ML2, the thickness of the third metal layer ML3, the thickness of the fourth metal layer ML4, the thickness of the fifth metal layer ML5, and the thickness of the sixth metal layer ML6. Each of the thickness of the seventh metal layer ML7 and the thickness of the eighth metal layer ML8 may be greater than each of the thickness of the seventh via VA7 and the thickness of the eighth via VA8. Each of the thickness of the seventh via VA7 and the thickness of the eighth via VA8 may be greater than each of the thickness of the first via VA1, the thickness of the second via VA2, the thickness of the third via VA3, the thickness of the fourth via VA4, the thickness of the fifth via VA5, and the thickness of the sixth via VA6. The thickness of the seventh metal layer ML7 and the thickness of the eighth metal layer ML8 may be substantially the same as each other.

The ninth interlayer insulating layer INS9 may be located on the eighth interlayer insulating layer INS8 and the eighth metal layers ML8. The ninth interlayer insulating layer INS9 may be formed of a silicon oxide (SiOx)-based inorganic layer, but the present invention is not limited thereto.

Each of the ninth vias VA9 may be connected to the eighth metal layer ML8 exposed by passing through the ninth interlayer insulating layer INS9. The ninth vias VA9 may be formed of any one of copper (Cu), aluminum (Al), tungsten (W), molybdenum (Mo), chromium (Cr), gold (Au), titanium (Ti), nickel (Ni), or neodymium (Nd), or an alloy including any one of them.

The tenth interlayer insulating layers INS10 may be located on the ninth interlayer insulating layer INS9. The tenth interlayer insulating layer INS10 may overlap a pixel electrode AND of the light emission areas EA1, EA2, and EA3 that will be described later, and the tenth interlayer insulating layers INS10 may be spaced apart from each other. The tenth interlayer insulating layer INS10 may be formed of a silicon nitride (SiNx)-based inorganic layer, but the present invention is not limited thereto. The ninth vias VA9 may pass through the tenth interlayer insulating layer INS10.

The light-emitting element layer EML may be located on the light-emitting element backplane EBP. The light-emitting element layer EML may include a bank structure BNS, a pixel electrode AND, light-emitting layers IL1, IL2, and IL3, and light-emitting elements including a common electrode CAT, and a pixel-defining layer PDL.

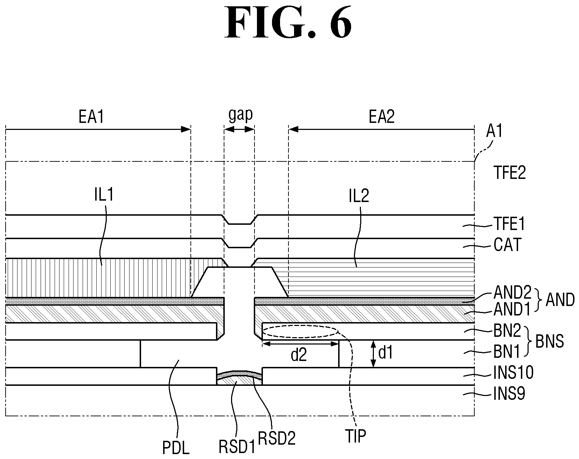

FIG. 6 is an enlarged view illustrating an area A1 of FIG. 5, and illustrates the bank structure BNS, the light-emitting elements, and the pixel-defining layer PDL of the light-emitting element layer EML.

Referring to FIGS. 5 and 6, the bank structure BNS may be located on the tenth interlayer insulating layer INS10, and may include a first bank pattern BN1 and a second bank pattern BN2. The bank structure BNS may overlap each of the light emission areas EA1, EA2, and EA3.

The bank structure BNS may be located on the tenth interlayer insulating layer INS10. The bank structure BNS may include a first bank pattern BN1 and a second bank pattern BN2, which are sequentially stacked. The bank structure BNS may include a plurality of patterns separated or spaced apart from each other, and each of the patterns of the bank structure BNS, which are spaced apart from each other, may overlap one light emission area EA1, EA2 or EA3. The pixel electrode AND separated without a mask may be formed due to the bank structures spaced apart from each other.

The first bank pattern BN1 may be located on the tenth interlayer insulating layer INS10. The first bank pattern BN1 may include a plurality of patterns, and the respective patterns may be spaced apart from each other. In one or more embodiments, the first bank pattern BN1 may be an island pattern. A planar shape of each island of the first bank pattern BN1 may be a circle or a polygon, such as a triangle and a square. The first bank pattern BN1 may be connected to the ninth via VA9. The first bank pattern BN1 and the ninth via VA9 may include the same material.

The first bank pattern BN1 may be located inside each of the light emission areas EA1, EA2, and EA3. The first bank pattern BN1 of the first light emission area EA1, the first bank pattern BN1 of the second light emission area EA2, and the first bank pattern BN1 of the third light emission area EA3 may be spaced apart from one another.

Sides of the first bank pattern BN1 may be more recessed toward centers of the light emission areas EA1, EA2, and EA3 than sides of the second bank pattern BN2 as well as sides of the pixel electrode AND.

The second bank pattern BN2 may be located on the first bank pattern BN1. The second bank pattern BN2 may include a plurality of patterns that may be spaced apart from each other. One second bank pattern BN2 may be formed on an upper surface of each of the plurality of first bank patterns BN1. In the same manner as the first bank pattern BN1, the second bank patterns BN2 may be separated or spaced apart from each other. The second bank pattern BN2 of the first light emission area EA1, the second bank pattern BN2 of the second light emission area EA2, and the second bank pattern BN2 of the third light emission area EA3 may be spaced apart from one another. In one or more embodiments, the second bank pattern BN2 may be an island pattern.

The second bank pattern BN2 may include a tip TIP that is an area that protrudes further than the first bank pattern BN1. A width of the second bank pattern BN2 may be greater than that of the first bank pattern BN1. The sides of the second bank pattern BN2 may protrude further than the sides of the first bank pattern BN1 in a direction opposite to a direction directed toward the centers of the light emission areas EA1, EA2, and EA3. As the side of the second bank pattern BN2 has a shape that protrudes further than the side of the first bank pattern BN1, an undercut structure of the first bank pattern BN1 may be formed below the tip TIP of the second bank pattern BN2. A portion of a lower surface of the second bank pattern BN2 and a lower surface of the tip TIP may be exposed without being covered with the first bank pattern BN1.

To manufacture the display device 10 of ultra-high resolution, a gap between the pixel electrodes AND may be very narrow. To manufacture the pixel electrodes AND by the mask process, a structure for holding a mask may be suitable, or an unnecessarily wide non-display area NDA may be suitable to control dispersion according to the mask process. In addition, when the pixel electrode AND is manufactured through a wet etching process, due to an etch skew, the width of the pixel electrode AND may be narrower than a target width, and the non-display area may be widened.

As the bank structure BNS of the display device 10 according to one or more embodiments includes a tip TIP and an undercut, layers spaced apart from each other may be formed on the top of the bank structure BNS by a deposition process instead of the mask process. For example, even though the pixel electrode AND is formed by a deposition process that does not use a mask, materials deposited on an entire surface of the display device 10 may be disconnected by the tip TIP of the second bank pattern BN2 without being connected among the light emission areas EA1, EA2, and EA3. Also, the etching process subsequent to the mask process may be omitted. In the display device 10, unnecessary elements, such as a structure for holding a mask, may be omitted, and the non-display area NDA for dispersion control may be reduced or minimized. Also, an interval between pixels may be reduced so that extreme resolution may be implemented.

Lateral shapes of the first bank pattern BN1 and the second bank pattern BN2 may have a structure in which the first bank pattern BN1 and the second bank pattern BN2 include materials that different from each other, and that are formed due to a difference in etching rates during an etching process. According to one or more embodiments, the second bank pattern BN2 may include a material having an etching rate that is slower than that of the first bank pattern BN1, and the first bank pattern BN1 may be further etched during the etching process so that an undercut may be formed below the tip TIP of the second bank pattern BN2.

The first bank pattern BN1 and the second bank pattern BN2 may include different metals or alloys. In one or more embodiments, the first bank pattern BN1 may include aluminum (Al) or an aluminum alloy, and the second bank pattern BN2 may include titanium (Ti) or a titanium alloy.

A distance d2 between the side of the first bank pattern BN1 and the side of the second bank pattern BN2, that is, a width d2 on a lower surface of the tip TIP of the second bank pattern BN2 may be greater than a thickness d1 of the first bank pattern BN1. In one or more embodiments, a distance d2 between the side of the first bank pattern BN1 and the side of the second bank pattern BN2 may be about three times to about five times the thickness d1 of the first bank pattern BN1. In this range, when the pixel electrode AND is deposited, the pixel electrode AND is not formed on the side of the first bank pattern BN1, and the likelihood of the occurrence of a short of the light-emitting element may be reduced or prevented.

The light-emitting elements may be located on the second bank pattern BN2, and may include the pixel electrode AND, the light-emitting layers IL1, IL2, and IL3, and the common electrode CAT, respectively. The light emission areas EA1, EA2, and EA3 are areas where the pixel electrode AND, the light-emitting layers IL1, IL2, and IL3 and the common electrode CAT are sequentially stacked, and may be defined as the pixel-defining layers PDL that will be described later.

The pixel electrode AND may be located on the second bank pattern BN2. The pixel electrode AND may be electrically connected to the ninth via VA9 through the bank structure BNS having conductivity, and then may be connected to the drain area DA or the source area SA of the pixel transistor PTR through the first to eighth vias VA1, VA2, VA3, VA4, VA5, VA6, VA7, and VA8, the first to eighth metal layers ML1, ML2, ML3, ML4, ML5, ML6, ML7, and ML8, and the contact terminal CTE.

The pixel electrode AND may be located not only on the upper surface of, but also on the side(s) of, the second bank pattern BN2. The pixel electrode AND may be formed through a sputtering process, and a portion of the pixel electrode AND may be also formed on the side(s) of the second bank pattern BN2.

The pixel electrode AND may be made of any one of a metal, such as copper (Cu), aluminum (Al), tungsten (W), molybdenum (Mo), chromium (Cr), gold (Au), titanium (Ti), nickel (Ni), or neodymium (Nd), or a transparent conductive oxide (TCO), or a metal alloy. One or more of indium tin oxide (ITO), indium zinc oxide (ITO), indium tin zinc oxide (ITZO), Zinc-Indium-Tin Oxide (ZITO), Indium-Gallium-Zinc Oxide (IGZO), Indium-Tin Oxide (IZO), or Zinc-Tin Oxide (ZTO) may be used as the material of the transparent conductive oxide (TCO).

The pixel electrode AND may have a single layered structure or a multi-layered structure. In one or more embodiments, the pixel electrode may have a multi-layered structure. The pixel electrode AND may include a first layer AND1 located on the second bank pattern BN2 and including a metal, and a second layer AND2 located on the first layer AND1 and including a transparent conductive oxide (TCO). In one or more embodiments, the first layer AND1 may include silver (Ag), and the second layer AND2 may include ITO.

Residual patterns RSD1 and RSD2 may be located on the ninth interlayer insulating layer INS9 in gap spaces among the plurality of light emission areas EA1, EA2, and EA3.

A material deposited on an entire surface of the substrate SSUB during deposition of the pixel electrode AND is disconnected by the tip TIP of the second bank pattern BN2, and the residual patterns RSD1 and RSD2 are formed on the ninth interlayer insulating layer INS9. The residual patterns RSD1 and RSD2 may be located in a gap space of the tenth interlayer insulating layer INS10, and may overlap a gap space or a gap between the pixel electrodes AND. The residual patterns RSD1 and RSD2 may be located at a position or level lower than that of the second bank pattern BN2.

The residual patterns RSD1 and RSD2 may include the same material as that of the pixel electrode AND. When the pixel electrode AND has a multi-layered structure, the residual patterns RSD1 and RSD2 may also have a multi-layered structure, and the stacked structure of the residual patterns RSD1 and RSD2 may be the same as that of the pixel electrode AND. In one or more embodiments, the residual pattern may include a first residual pattern RSD1 that is located on the ninth interlayer insulating layer and that includes the same material as that of the first layer AND1, and may include a second residual pattern RSD2 that is located on the first residual pattern RSD1 and that includes the same material as that of the second layer AND2.

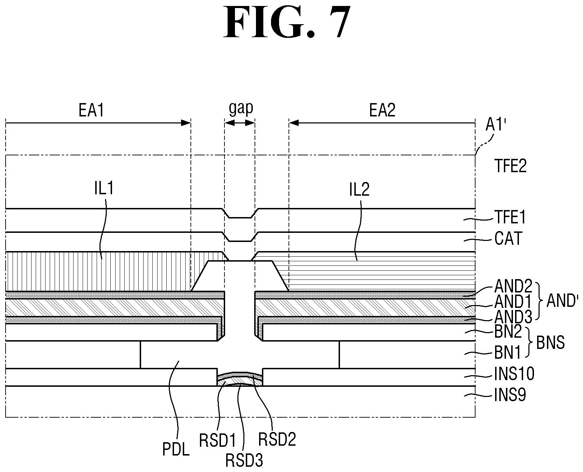

FIG. 7 is a cross-sectional view illustrating a portion of a display panel according to one or more embodiments. FIG. 7 is different from FIG. 6 in that a pixel electrode AND' further includes a third layer AND3 at a lower portion thereof.

The third layer AND3 may be located between the second bank pattern BN2 and the first layer AND1, and may include a transparent conductive oxide (TCO). In one or more embodiments, the third layer AND3 may include the same material as that of the second layer AND2.

As the pixel electrode AND' further includes the third layer AND3, the residual pattern may further include the third residual pattern RSD3 at a lower portion thereof. The third residual pattern RSD3 may be located between the ninth interlayer insulating layer INS9 and the first residual pattern RSD1. Other elements except for the third layer AND3 of the pixel electrode AND' and the third residual pattern RSD3 may be the same as those described in FIG. 6.

Referring to FIGS. 5 and 6, the pixel-defining layer PDL may surround the first bank pattern BN1, the second bank pattern BN2 and the pixel electrode AND, and may be located on the residual patterns RSD1 and RSD2 and the tenth interlayer insulating layer INS10. A portion of the pixel-defining layer PDL may be located on the edge of the pixel electrode AND. The pixel-defining layer PDL may define first light emission areas EA1, second light emission areas EA2, and third light emission areas EA3.

The first light emission area EA1 may be defined as an area in which the pixel electrode AND, the first light-emitting layer IL1, and the common electrode CAT are sequentially stacked in the first subpixel SP1 to emit light. The second light emission area EA2 may be defined as an area in which the pixel electrode AND, the second light-emitting layer IL2, and the common electrode CAT are sequentially stacked in the second subpixel SP2 to emit light. The third light emission area EA3 may be defined as an area in which the pixel electrode AND, the third light-emitting layer IL3, and the common electrode CAT are sequentially stacked in the third subpixel SP3 to emit light.

The pixel-defining layer PDL may include an inorganic insulating material. The pixel-defining layer PDL may include at least one of silicon nitride, silicon oxynitride, silicon oxide, titanium oxide, aluminum oxide, tantalum oxide, hafnium oxide, zinc oxide, or amorphous silicon, but is not limited thereto.

The pixel-defining layer PDL may fill the undercut of the first bank pattern BN1 below the tip TIP of the second bank pattern BN2. The pixel-defining layer PDL may be located on the lower surface of the second bank pattern BN2, the side of the first bank pattern BN1, the upper surface of the tenth interlayer insulating layer INS10, and the upper surfaces of the residual patterns RSD1 and RSD2.

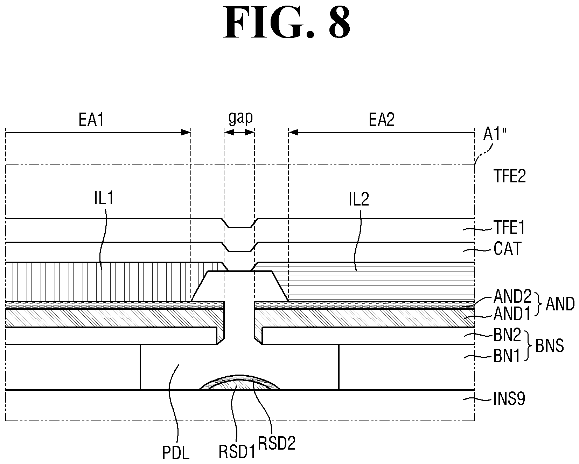

FIG. 8 is a cross-sectional view illustrating a portion of a display panel according to one or more embodiments. FIG. 8 is different from FIG. 6 in that the tenth interlayer insulating layer INS10 between the bank structure BNS and the ninth interlayer insulating layer INS9 is removed. The first bank pattern BN1, the pixel-defining layer PDL, and the first residual pattern RSD1 of FIG. 8 may be directly formed on the ninth interlayer insulating layer INS9.

Referring to FIG. 5, the light-emitting layer may include a first light-emitting layer IL1, a second light-emitting layer IL2, and a third light-emitting layer IL3. The light-emitting layers IL1, IL2, and IL3 may be organic light-emitting layers made of organic materials, and may be formed on the pixel electrode AND. Some of the light-emitting layers IL1, IL2, and IL3 may be located on the pixel-defining layer PDL.

The light-emitting layers IL1, IL2, and IL3 may have a multi-layered structure, and a hole injection material, a hole transport material, a light-emitting material, an electron transport material, and/or an electron injection material may form respective layers. When the pixel transistor PTR applies a voltage (e.g., predetermined voltage) to the pixel electrode AND of the light-emitting element, and when the common electrode CAT of the light-emitting element receives a common voltage or a cathode voltage, holes and electrons may be injected and transported respectively therefrom to be combined with each other in the light-emitting layers IL1, IL2, and IL3 to emit light.

The first to third light-emitting layers IL1, IL2, and IL3 may be located in the first to third light emission areas EA1, EA2, and EA3, respectively, to emit light of different colors. For example, the first light-emitting layer IL1 located in the first light emission area EA1 may emit red light having a peak wavelength in the range of about 610 nm to about 650 nm, and the second light-emitting layer IL2 located in the second light emission area EA2 may emit green light having a peak wavelength in the range of about 510 nm to about 550 nm, and the third light-emitting layer IL3 located in the third light emission area EA3 may emit blue light having a peak wavelength in the range of about 440 nm to about 480 nm. The first to third light emission areas EA1, EA2, and EA3 constituting one pixel may include light-emitting elements for emitting light of different colors to express a white gray level. Alternatively, the light-emitting layers IL1, IL2, and IL3 may include two or more materials for emitting light of different colors, such that one light-emitting layer may emit mixed light. For example, one of the light-emitting layers IL1, IL2, and IL3 may include a material for emitting red light and a material for emitting green light to emit yellow light, and another one thereof may emit blue light.

The light-emitting layers IL1, IL2, and IL3 may cover the pixel electrode AND in the opening of the pixel-defining layer PDL, and may cover the pixel-defining layer PDL between the adjacent subpixels SP1, SP2, and SP3, but a portion thereof may be disconnected.

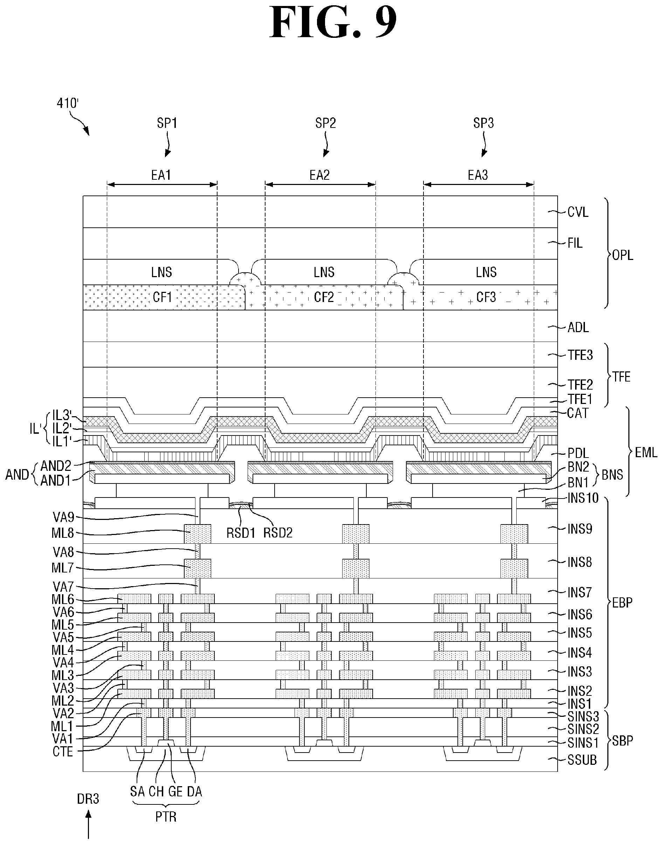

FIG. 9 is a cross-sectional view illustrating a portion of a display panel according to one or more embodiments. Referring to FIG. 9, a light-emitting layer IL' may have a tandem structure that includes a plurality of light-emitting layers IL1', IL2' and IL3' for emitting light of different colors. For example, the light-emitting layer IL' may include a first light-emitting layer IL1' for emitting light of a first color, a second light-emitting layer IL2' for emitting light of a second color, and a third light-emitting layer IL3' for emitting light of a third color. The first light-emitting layer IL1', the second light-emitting layer IL2', and the third light-emitting layer IL3' may be sequentially stacked. The light-emitting layer IL' may be formed on the entire surface of the substrate SSUB without being disconnected.

Referring to FIG. 5, the common electrode CAT may be located on the light-emitting layers IL1, IL2, and IL3 and on the pixel-defining layer PDL. The common electrode CAT may be formed of a transparent conductive oxide (TCO), such as ITO or IZO, which is capable of transmitting light, or a semi-transmissive conductive material, such as magnesium (Mg), silver (Ag), or an alloy of magnesium (Mg) and silver (Ag). When the common electrode CAT is formed of a semi-transmissive metal material, light-emitting efficiency from each of the first to third subpixels SP1, SP2, and SP3 may be increased by micro cavity.

The encapsulation layer TFE may be located on the light-emitting element layer EML. The encapsulation layer TFE may include at least one inorganic layer TFE1 or TFE3 to reduce or prevent oxygen or moisture being permeated into the light-emitting element layer EML. In addition, the encapsulation layer TFE may include at least one organic layer to protect the light-emitting element layer EML from particles, such as dust. For example, the encapsulation layer TFE may include a first encapsulation inorganic layer TFE1, an encapsulation organic layer TFE2 and a second encapsulation inorganic layer TFE3.

The first encapsulation inorganic layer TFE1 may be located on the common electrode CAT, the encapsulation organic layer TFE2 may be located on the first encapsulation inorganic layer TFE1, and the second encapsulation inorganic layer TFE3 may be located on the encapsulation organic layer TFE2. The first encapsulation inorganic layer TFE1 and the second encapsulation inorganic layer TFE3 may be formed of a multi-layer in which one or more of silicon nitride (SiNx), silicon oxynitride (SiON), silicon oxide (SiOx), titanium oxide (TiOx), or aluminum oxide (AlOx) are alternately stacked. The encapsulation organic layer TFE2 may be a monomer. Alternatively, the encapsulation organic layer TFE2 may be an organic layer, such as an acrylic resin, an epoxy resin, a phenolic resin, a polyamide resin, or a polyimide resin.

The adhesive layer ADL may be a layer for bonding the encapsulation layer TFE to the optical layer OPL. The adhesive layer ADL may be a double-sided adhesive member. In addition, the adhesive layer ADL may be a transparent adhesive member, such as a transparent adhesive or a transparent adhesive resin.

The optical layer OPL includes a plurality of color filters CF1, CF2, and CF3, a plurality of lenses LNS, and a filling layer FIL. The color filters may include first to third color filters CF1, CF2, and CF3. The first to third color filters CF1, CF2, and CF3 may be located on the adhesive layer ADL.

The color filters may include a first color filter CF1, a second color filter CF2, and a third color filter CF3, which respectively correspond to the different light emission areas EA1, EA2, and EA3. The color filters CF1, CF2, and CF3 may include a colorant, such as a dye or a pigment, which absorbs light of a different wavelength band other than light of a corresponding wavelength band, and may correspond to a color of light emitted from the light emission areas EA1, EA2, and EA3. For example, the first color filter CF1 may be a red color filter that overlaps the first light emission area EA1 and transmits only red light. The second color filter CF2 may be a green color filter that overlaps the second light emission area EA2 and transmits only green light. The third color filter CF3 may be a blue color filter that overlaps the third light emission area EA3 and transmits only blue light.

The plurality of lenses LNS may be respectively located on the first color filter CF1, the second color filter CF2, and the third color filter CF3. Each of the plurality of lenses LNS may be a structure for increasing a ratio of light directed toward a front surface of the display device 10. Each of the plurality of lenses LNS may have a cross-sectional shape that is convex upward.

The filling layer FIL may be located on the plurality of lenses LNS. The filling layer FIL may have a refractive index (e.g., predetermined refractive index) so that light moves in the third direction DR3 on an interface between the plurality of lenses LNS and the filling layer FIL. Also, the filling layer FIL may be a planarization layer. The filling layer FIL may be an organic layer, such as an acrylic resin, an epoxy resin, a phenolic resin, a polyamide resin, or a polyimide resin.

The cover layer CVL may be located on the filling layer FIL. The cover layer CVL may be a glass substrate or a polymer resin. When the cover layer CVL is a glass substrate, the cover layer CVL may be attached onto the filling layer FIL. In this case, the filling layer FIL may serve to adhere the cover layer CVL. When the cover layer CVL is a glass substrate, the cover layer CVL may serve as an encapsulation substrate. When the cover layer CVL is a polymer resin, such as a resin, the cover layer CVL may be directly coated on the filling layer FIL.

In one or more embodiments, a polarizing plate may be located on one surface of the cover layer CVL. The polarizing plate may be a structure for reducing or preventing deterioration of visibility, which may be caused by reflection of external light. The polarizing plate may include a linear polarizing plate and a phase delay film. For example, the phase delay film may be a quarter-wave plate (λ/4 plate), but the present invention is not limited thereto. However, when visibility due to reflection of external light is sufficiently improved by the first to third color filters CF1, CF2, and CF3, the polarizing plate may be omitted.

Hereinafter, a manufacturing process of the display device 10 according to one or more embodiments will be described with reference to other drawings.

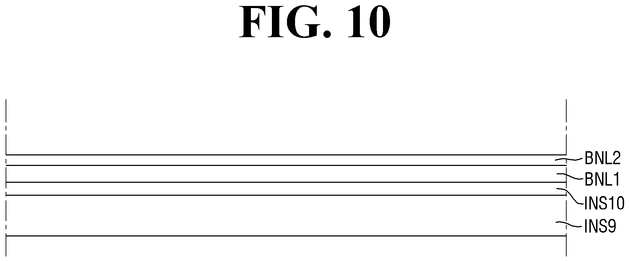

FIGS. 10 to 16 are cross-sectional views sequentially illustrating a process of manufacturing a display device according to one or more embodiments. FIGS. 10 to 16 schematically illustrate a process of forming a bank structure BNS, a pixel electrode AND, and a pixel-defining layer PDL. Hereinafter, the description of the process of forming each layer with respect to the manufacturing process of the display device 10 will be omitted, and the formation order of each layer will be described.

Referring to FIG. 10, a tenth interlayer insulating layer INS10, a first bank layer BNL1, and a second bank layer BNL2 are sequentially formed on the ninth interlayer insulating layer INS9. In one or more embodiments, the ninth interlayer insulating layer INS9 may be located on the first to eighth interlayer insulating layers INS1, INS2, INS3, INS4, INS5, INS6, INS7, and INS8 and on the first to eighth metal layers ML1, ML2, ML3, ML4, ML5, ML6, ML7, and ML8 of the semiconductor backplane SBP and the light-emitting element backplane EBP, and its detailed structure may be the same as that described with reference to FIG. 5. A repeated detailed description corresponding thereto will be omitted.

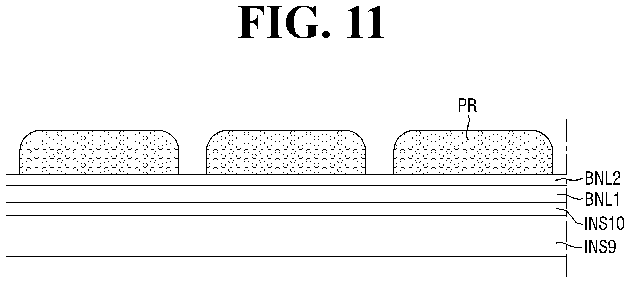

Referring to FIG. 11, a photoresist PR is formed on the second bank layer BNL2. The photoresist PR may be located in an area(s) that overlaps the light emission areas EA1, EA2, and EA3.

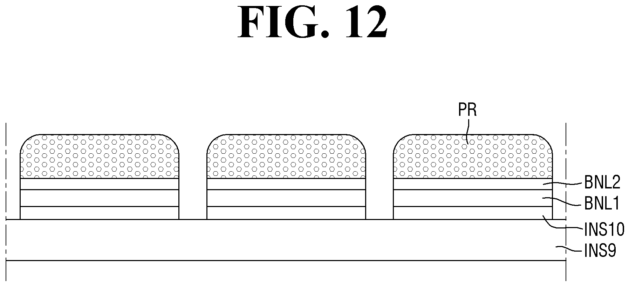

Next, referring to FIG. 12, a first etching process of patterning the second bank layer BNL2, the first bank layer BNL1, and the tenth interlayer insulating layer INS10 may be performed using the photoresist PR as a mask pattern. In one or more embodiments, the first etching process may be anisotropic dry etching. Through the first etching process, the second bank layer BNL2, the first bank layer BNL1, and the tenth interlayer insulating layer INS10 in an area(s) not covered with the mask pattern may be removed to form a plurality of holes.

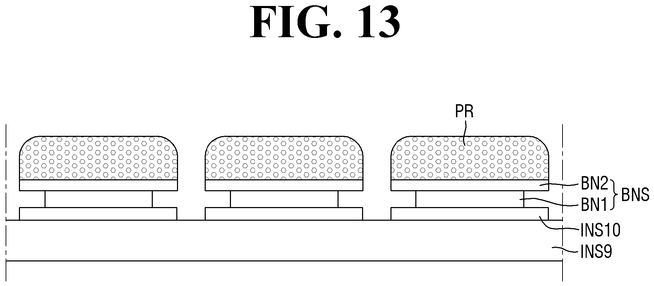

Subsequently, referring to FIG. 13, a second etching process of etching the side of the first bank layer BNL1 may be performed so that a portion of a lower surface of the second bank layer BNL2 is exposed. In one or more embodiments, the second etching process may be isotropic wet etching. The first bank pattern BN1 and the second bank pattern BN2, which include an undercut structure, may be obtained through the second etching process.

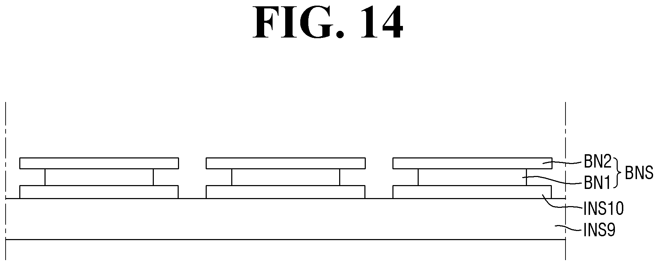

Next, referring to FIG. 14, the photoresist PR of the mask pattern may be removed.

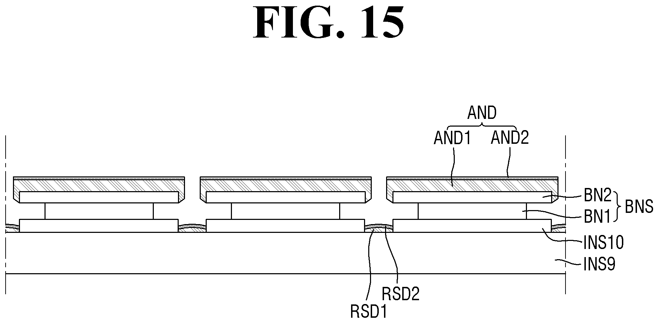

Subsequently, referring to FIG. 15, the pixel electrode AND may be formed on the second bank pattern BN2, and residual patterns RSD1 and RSD2 may be formed on the ninth interlayer insulating layer INS9. A material of the pixel electrode AND may be deposited on an entire surface thereof, and then disconnected by the tip TIP of the second bank pattern BN2, whereby the material of the pixel electrode AND may be divided into the pixel electrodes AND and the residual patterns RSD1 and RSD2. The pixel electrode AND includes a first layer AND1 and a second layer AND2, and the residual pattern may also include a first residual pattern RSD1 and a second residual pattern RSD2.

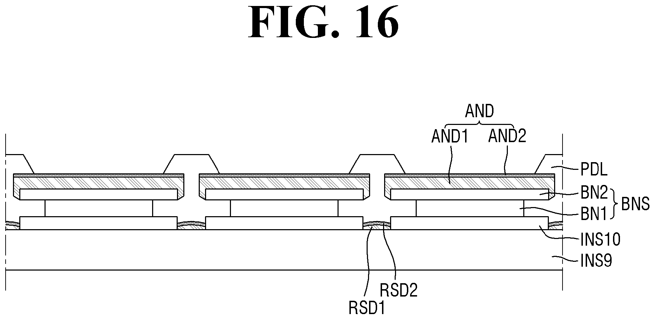

Next, referring to FIG. 16, the pixel-defining layer PDL may be formed to fill the undercut of the bank structure BNS, and may cover the residual patterns RSD1 and RSD2. The pixel-defining layer PDL may cover an edge of the pixel electrode AND while surrounding the pixel electrode AND.

Subsequently, in one or more embodiments, the light-emitting layers IL1, IL2, and IL3, the common electrode CAT, the encapsulation layer TFE, the adhesive layer ADL, and the optical layer OPL are formed so that the display device 10 is manufactured. The descriptions of the light-emitting layers IL1, IL2, and IL3, the common electrode CAT, the encapsulation layer TFE, the adhesive layer ADL, and the optical layer OPL may be the same as those described above, and thus repeated detailed descriptions thereof will be omitted.

Although the embodiments of the present invention have been described with reference to the accompanying drawings, it will be apparent to those skilled in the art that the present invention can be manufactured in various forms without being limited to the above-described embodiments and can be embodied in other forms without departing from related characteristics of the claims. Thus, the above embodiments are to be considered in all respects as illustrative and not restrictive.

## Claims

1. A display device (10) comprising:
a substrate (SSUB);
a first bank pattern (BN1) above the substrate (SSUB);
a second bank pattern (BN2) above the first bank pattern (BN1) and comprising a side protruding further than the first bank pattern (BN1); and
a pixel electrode (AND) above the second bank pattern (BN2).

2. The display device (10) of claim 1, wherein the first bank pattern (BN1) and the second bank pattern (BN2) comprise different respective metals or alloys, especially wherein the first bank pattern (BN1) comprises aluminum or an aluminum alloy, and
wherein the second bank pattern (BN2) comprises titanium or a titanium alloy.

3. The display device (10) of claim 1 or 2, wherein the substrate (SSUB) comprises light emission areas (EA1, EA2, EA3) spaced apart from each other, especially a first light emission area (EA1) and a second light emission area (EA2) spaced apart from each other, and
wherein the display device (10) further comprising a residual pattern (RSD1, RSD2) in a space between the light emission areas (EA1, EA2, EA3).

4. The display device (10) of claim 3, wherein the first bank pattern (BN1) is above the substrate (SSUB) in the light emission areas (EA1, EA2, EA3), and wherein the display device (10) further comprises:
a pixel-defining layer (PDL) above the residual pattern (RSD1, RSD2) and especially above the pixel electrode (AND); and
especially a light-emitting layer (IL1, IL2, IL3) above the pixel electrode (AND) and the pixel-defining layer (PDL).

5. The display device (10) of claim 3 or 4, wherein the residual pattern (RSD1, RSD2) comprises a same material as the pixel electrode (AND).

6. The display device (10) of at least one of claims 3 to 5, wherein the residual pattern (RSD1, RSD2) is lower than the second bank pattern (BN2).

7. The display device (10) of at least one of claims 4 to 6, wherein the pixel-defining layer (PDL) surrounds the first bank pattern (BN1), the second bank pattern (BN2), and the pixel electrode (AND).

8. The display device (10) of at least one of claims 4 to 7, wherein the pixel-defining layer (PDL) is above a lower surface of the second bank pattern (BN2).

9. The display device (10) of at least one of claims 1 to 8, wherein a distance (d2) between a side of the first bank pattern (BN1) and a side of the second bank pattern (BN2) is greater than a thickness (d1) of the first bank pattern (BN1), especially wherein the distance (d2) between the side of the first bank pattern (BN1) and the side of the second bank pattern (BN2) is about three times to about five times the thickness (d1) of the first bank pattern (BN1).

10. The display device (10) of at least one of claims 1 to 9, wherein the pixel electrode (AND) is on an upper surface and a side of the second bank pattern (BN2).

11. The display device (10) of at least one of claims 1 to 10, wherein the pixel electrode (AND) comprises:
a first layer (AND1) comprising a metal above the second bank pattern (BN2); and
a second layer (AND2) comprising a transparent conductive oxide above the first layer (AND1).

12. The display device (10) of claim 11, wherein the pixel electrode (AND) further comprises a third layer (AND3) comprising a metal between the second bank pattern (BN2) and the first layer (AND1).

13. The display device (10) of at least one of claims 3 to 12, further comprising an interlayer insulating layer (INS10) between the substrate (SSUB) and the first bank pattern (BN1) in the first light emission area (EA1) and in the second light emission area (EA2).

14. The display device (10) of claim 13, wherein the interlayer insulating layer (INS10) in the first light emission area (EA1) and the interlayer insulating layer (INS10) in the second light emission area (EA2) are spaced apart from each other, and
wherein the residual pattern (RSD1, RSD2) is in a gap space of the interlayer insulating layer (INS10).

15. The display device (10) of at least one of claims 1 to 14, wherein the first bank pattern (BN1) and the second bank pattern (BN2) comprise island patterns.

16. A method for manufacturing a display device (10), the method comprising:
forming a first bank layer (BNL1) above a substrate (SSUB);
forming a second bank layer (BNL2) above the first bank layer (BNL1);
removing a portion of the second bank layer (BNL2) and the first bank layer BNL1);
etching a side of the first bank layer (BNL1) to expose a portion of a lower surface of the second bank layer (BNL2);
forming a pixel electrode (AND) above the second bank layer (BNL2); and
forming a residual pattern (RSD1, RSD2) above the substrate (SSUB).

17. The method of claim 16, wherein the forming a pixel electrode (AND) above the second bank layer (BNL2) and the forming a residual pattern (RSD1, RSD2) above the substrate (SSUB) comprises dividing a material deposited on the substrate (SSUB) into the pixel electrode (AND) and the residual pattern (RSD1, RSD2) by being disconnected by a protruded side of the second bank layer (BNL2) extending further than the first bank layer (BNL1).

18. The method of claim 16 or 17, wherein the removing a portion of the second bank layer (BNL2) and the first bank layer (BNL1) comprises:
forming a mask pattern above the second bank layer (BNL2); and
etching the second bank layer (BNL2) and the first bank layer (BNL1) in an area not covered with the mask pattern.
